# EUROPEAN PATENT SPECIFICATION

(11) **EP 0 792 016 B1**
(45) Date of publication and mention of the grant of the patent: **16.08.2000**
(21) Application number: 97301230.5
(22) Date of filing: 25.02.1997
(51) Int. Cl.: H03G 3/20, G11B 20/10

(54) **Signal-processing preamplifier for optical disc system**
Signalverarbeitungsvorverstärker für eine Vorrichtung für optische Platte
Préamplificateur de traitement de signal pour un système à disque optique

(30) Priority: 26.02.1996 KR 9604650
(43) Date of publication of application: 27.08.1997
(73) Proprietor: Samsung Electronics Co., Ltd., Suwon City, Kyungki-do (KR)
(72) Inventor: Kim, Chun-Sup, Paldal-gu, Suwon-city, Kyungki-do (KR); Kim, Yong-Serk, Paldal-gu, Suwon-city, Kyungki-do (KR)
(74) Representative: Chugg, David John

(56) References cited:
- EP-A- 0 406 852
- EP-A- 0 429 045
- US-A- 3 725 646
- US-A- 4 380 777
- US-A- 4 433 254
- PATENT ABSTRACTS OF JAPAN vol. 095, no. 003, 28 April 1995 & JP 06 334459 A (YAMAHA CORP), 2 December 1994,

## Description

The present invention relates to an optical disc system, and more particularly to a signal-processing preamplifier for an optical disc system which is capable of compensating for a signal attenuation generated during a reproduction of signals from an optical disc such as a mini disc or digital video disc due to an instantaneous variation in the rotating speed of the optical disc or particular characteristics of the optical disc.

Conventional preamplifiers used in optical disc systems have a complex circuit configuration because they should use various equalization amplifiers having different characteristics respectively meeting different kinds of optical discs. Furthermore, such conventional preamplifiers can not cope with an increase or decrease in amplitude of signals, reproduced from an optical disc, depending on an instantaneous variation in speed of the optical disc. In addition, the conventional preamplifiers have a degraded accuracy because they should use various amplifiers respectively requiring different control operations.

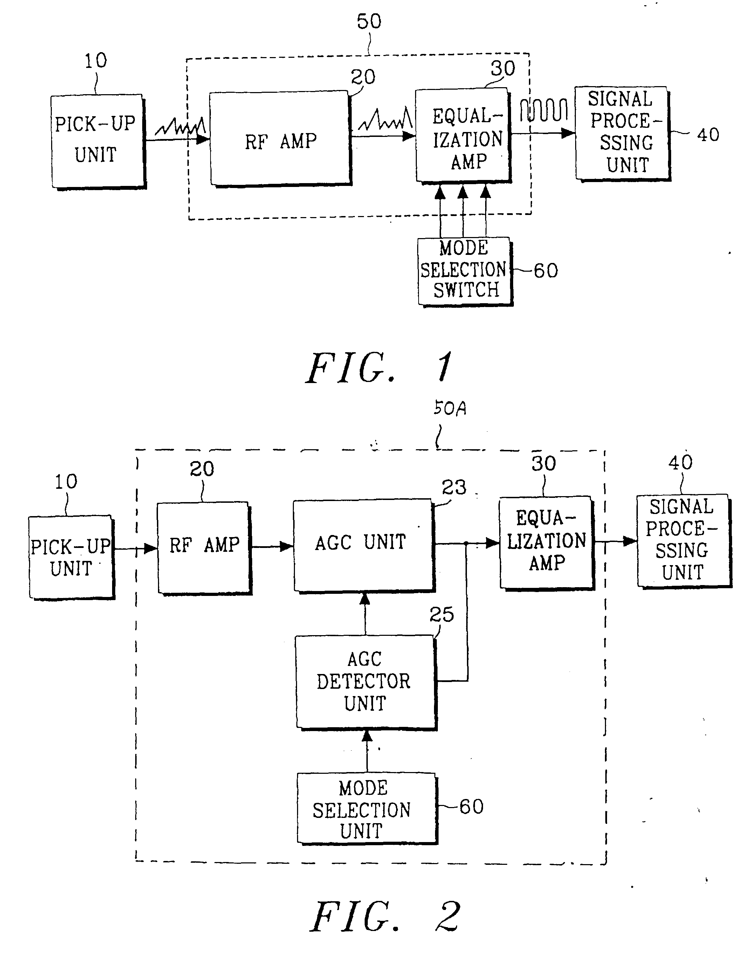

Figure 1 is a block diagram illustrating the configuration of a conventional preamplifier. Referring to Figure 1, an optical disc system is shown which may be an MD or DVD system. The optical disc system includes a pick-up unit 10 for reading an optical signal from an optical disc, a radio frequency (RF) amplifier 20 for amplifying the read signal, an equalization amplifier 30 for varying the frequency characteristic of the optical signal in accordance with the kind of optical disc, a signal processing unit 40 for appropriately processing the optical signal output from the equalization amplifier 30, and a preamplifier 50. Since the read signal output from the pick-up unit 10 has a very small amplitude, it is amplified by the RF amplifier 20. The amplified signal is then sent to the equalization amplifier 30 which, in turn, generates a signal having a desired level. The output signal from the equalization amplifier 30 is then sent to the signal processing unit 40. Although only one equalization amplifier is shown in Figure 1, the optical disc system has a plurality of equalization amplifiers respectively corresponding to operation modes thereof. In a DVD system which has at least six operation modes, at least six equalization amplifiers having different equalization characteristics are used. An appropriate one of the equalization amplifiers is selected by a mode selection switch 60 in accordance with a selected operation mode.

EP-A-0406852 (Hitachi) discloses an automatic gain control method in an optical disc system, for distinguishing between a preformat portion of an optical disc and a reproduction signal from a recording portion of the optical disc which contains user data. This document discloses an optical disc system which in general has the features of the pre-characterising portion of claim 1 appended hereto.

Therefore, it is an aim of embodiments of the invention to provide a preamplifier for an optical disc system which uses an automatic gain control (AGC) system, thereby obtaining a constant response and a stable output signal for input signals of a certain amplitude.

In accordance with the present invention, there is provided an optical disc system, comprising: a pick-up unit for reading an optical signal from an optical disc; a signal processing unit for processing the optical signal; and a preamplifier comprising: a radio frequency amplifier for amplifying an output signal from the pick-up unit; an automatic gain control unit for amplifying an output signal from the radio frequency amplifier to a desired level; an automatic gain control detector unit coupled at its input terminal to an output terminal of the automatic gain control unit and at its output terminal to an input terminal of the automatic gain control unit, the automatic gain control detector unit serving to rectify an output signal from the automatic gain control unit, to compare the rectified signal with a reference signal having a predetermined level and to send the resultant signal obtained by the comparison to the automatic gain control unit; and a mode selecting unit coupled to the automatic gain control detector unit and adapted to select one of several modes respectively corresponding to different equalization characteristics; characterised in that: said automatic gain control detector unit comprises: a full-wave rectifier for outputting a full-wave rectified linear signal in response to a signal amplified by the automatic gain control unit; a logarithmic amplifier for receiving the linear signal output from the full-wave rectifier and outputting a logarithmically amplified signal; an integrator for receiving the output signal from the logarithmic amplifier and converting it into a DC signal; and a comparator for receiving a reference signal from an automatic gain control level controlling terminal at one input terminal thereof and the output signal from the integrator at the other input terminal thereof, comparing the received signals with each other, and sending the resultant signal obtained by the comparison to the automatic gain control unit.

Preferably, the preamplifier further comprises an equalization amplifier for stably outputting a particular frequency at a constant level to allow both the automatic gain control unit and the automatic gain control detector unit to adjust characteristics of the particular frequency.

Preferably, both the automatic gain control unit and the automatic gain control detector unit serve to adjust characteristics of a particular frequency, thereby stably outputting the particular frequency at a constant level.

Preferably, the automatic gain control unit comprises a voltage control amplifier which is controlled by voltage.

For a better understanding of the invention, and to show how embodiments of the same may be carried into effect, reference will now be made, by way of example, to the accompanying diagrammatic drawings, in which:
Figure 1 is a block diagram illustrating the configuration of a prior art preamplifier;
Figure 2 is a block diagram illustrating the configuration of a signal-processing preamplifier in accordance with an embodiment of the present invention; and
Figure 3 is a block diagram illustrating an AGC unit and an AGC detector unit both included in the signal-processing preamplifier of Figure 2.

Referring to Figure 2, an optical disc system using a signal-processing preamplifier according to an embodiment of the present invention is illustrated. In Figure 2, elements respectively corresponding to those in Figure 1 are denoted by the same reference numerals.

Figure 2 is a block diagram illustrating the configuration of the signal-processing preamplifier according to the present invention. As shown in Figure 2, the optical disc system has a configuration similar to that in Figure 1 except for the configuration of the signal-processing preamplifier. That is, the signal-processing preamplifier 50A of Figure 2 includes an AGC unit 23 for amplifying an output signal from the RF amplifier 20 to a desired level, an AGC detector unit 25 coupled at its input terminal to the output terminal of the AGC unit 23 and at its output terminal to the input terminal of the AGC unit 23, and a mode selecting unit 60 coupled to the AGC detector unit 25. An equalization amplifier 30 is also provided which serves to control characteristics of a particular frequency. An output signal from the RF amplifier 20 is adjusted to a desired level by the AGC unit 23 and AGC detector unit 25. In other words, the AGC unit 23 and AGC detector unit 25 operate to perform the function which is achieved by the equalization amplifier of the conventional configuration.

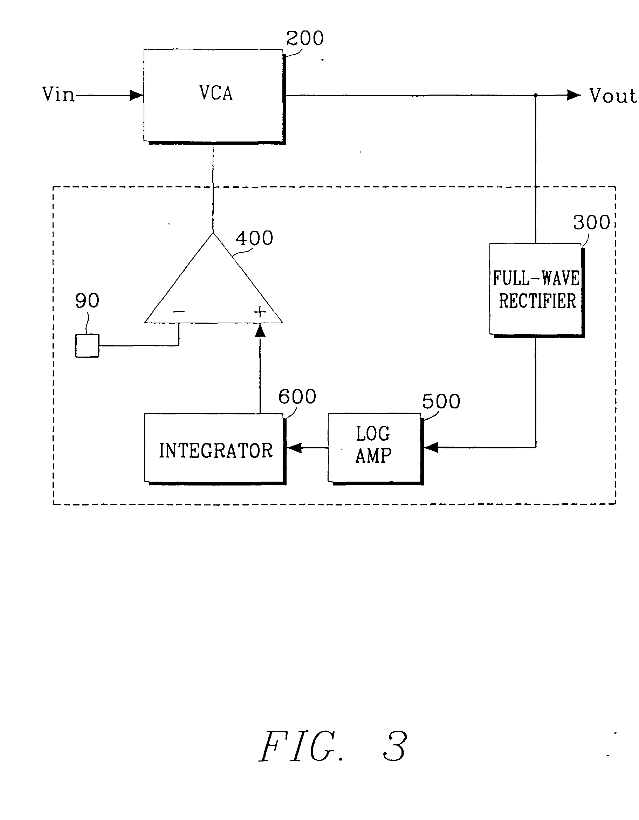

Figure 3 is a block diagram illustrating the AGC unit 23 and AGC detector unit 25 of the preamplifier which is denoted by the reference numeral 50A. The AGC unit 23 comprises a voltage control amplifier (VCA) 200 for amplifying an input signal Vin. On the other hand, the AGC detector unit 25 includes a full-wave rectifier 300 for outputting a full-wave rectified signal in response to the amplified signal from the VCA 200, a logarithmic amplifier 500 for receiving a linear signal, which may be the full-wave rectified signal from the full-wave rectifier 300, and outputting a logarithmically amplified signal, and an integrator 600 for receiving the output signal from the logarithmic amplifier 500 and converting it into a DC signal. The AGC detector unit 25 further includes a comparator 400 coupled at one input terminal to an AGC level controlling terminal 90 which provides a reference signal. The comparator 400 receives the output signal from the integrator 600 at the other input terminal thereof. The comparator 400 sends its output obtained by its comparison operation to the VCA 200.

As apparent from the above description, embodiments of the present invention provide a signal-processing preamplifier which uses an automatic gain control (AGC) system, thereby obtaining a constant response and a stable output signal for input signals of a certain amplitude.

## Claims

1. An optical disc system, comprising:
a pick-up unit (10) for reading an optical signal from an optical disc;
a signal processing unit (40) for processing the optical signal; and
a preamplifier (50A) comprising:
a radio frequency amplifier (20) for amplifying an output signal from the pick-up unit (10);
an automatic gain control unit (23) for amplifying an output signal from the radio frequency amplifier (20) to a desired level;
an automatic gain control detector unit (25) coupled at its input terminal to an output terminal of the automatic gain control unit and at its output terminal to an input terminal of the automatic gain control unit (23), the automatic gain control detector unit (25) serving to rectify an output signal from the automatic gain control unit (23), to compare the rectified signal with a reference signal having a predetermined level and to send the resultant signal obtained by the comparison to the automatic gain control unit (23); and
a mode selecting unit (60) coupled to the automatic gain control detector unit and adapted to select one of several modes respectively corresponding to different equalization characteristics;
characterised in that:
said automatic gain control detector unit (25) comprises:
a full-wave rectifier (300) for outputting a full-wave rectified linear signal in response to a signal amplified by the automatic gain control unit (23);
a logarithmic amplifier (500) for receiving the linear signal output from the full-wave rectifier (300) and outputting a logarithmically amplified signal;
an integrator (600) for receiving the output signal from the logarithmic amplifier (500) and converting it into a DC signal; and
a comparator (400) for receiving a reference signal from an automatic gain control level controlling terminal (90) at one input terminal thereof and the output signal from the integrator (600) at the other input terminal thereof, comparing the received signals with each other, and sending the resultant signal obtained by the comparison to the automatic gain control unit (23).

2. The optical disc system of claim 1, further comprising an equalization amplifier (30) for stably outputting a particular frequency at a constant level to allow both the automatic gain control unit (23) and the automatic gain control detector unit (25) to adjust characteristics of the particular frequency.

3. The optical disc system of claim 1 or 2, wherein both the automatic gain control unit (23) and the automatic gain control detector unit (25) serve to adjust characteristics of a particular frequency, thereby stably outputting the particular frequency at a constant level.

4. The optical disc system of claim 1, 2 or 3, wherein the automatic gain control unit (23) comprises a voltage control amplifier (200) which is controlled by voltage.

## Patentansprüche

1. Eine Vorrichtung für optische Platte, umfassend:
eine Abtasteinheit (10) zum Lesen eines optischen Signals von einer optischen Platte;
eine Signalverarbeitungseinheit (40) zum Verarbeiten des optischen Signals; und
einen Vorverstärker (50A) umfassend:
einen Radiofrequenzverstärker (20) zum Verstärken eines Ausgabesignals der Abtasteinheit (10);
eine automatische Verstärkungssteuerungseinheit (23) zum Verstärken eines Ausgabesignals des Radiofrequenzverstärkers (20) auf einen gewünschten Pegel;
eine automatische Verstärkungssteuerungsdetektoreinheit (25), deren Eingabeanschluß mit einem Ausgabeanschluß der automatischen Verstärkungssteuerungseinheit und deren Ausgabeanschluß mit einem Eingabeanschluß der automatischen Verstärkungssteuerungseinheit (23) verschaltet ist, wobei die automatische Verstärkungssteuerungsdetektoreinheit (25) dazu dient, ein Ausgabesignal der automatischen Verstärkungssteuerungseinheit (23) gleichzurichten, zum Vergleichen des gleichgerichteten Signals mit einem Referenzsignal, das einen vorbestimmten Pegel aufweist, und zum Senden des resultierenden Signals, das durch den Vergleich erzielt wurde, zu der automatischen Verstärkungssteuerungseinheit (23); und
eine Betriebsartauswahleinheit (60), die mit der automatischen Verstärkungssteuerungsdetektoreinheit verschaltet ist und geeignet ist zum Auswählen einer von mehreren Betriebsarten, die jeweils unterschiedlichen Entzerrungseigenschaften entsprechen;
dadurch gekennzeichnet, daß
die automatische Verstärkungssteuerungsdetektoreinheit (25) umfaßt:
einen Zweiweggleichrichter (300) zum Ausgeben eines zweiweggleichgerichteten linearen Signals in Reaktion auf ein Signal, das von der automatischen Verstärkungssteuerungseinheit (23) verstärkt wird;
einen logarithmischen Verstärker (500) zum Empfangen des von dem Zweiweggleichrichter (300) ausgegebenen linearen Signals und zum Ausgeben eines logarithmisch verstärkten Signals;
einen Integrator (600) zum Empfangen des Ausgabesignals des logarithmischen Verstärkers (500) und zum Umwandeln dieses Signals in ein Gleichstromsignal; und
einen Komparator (400) zum Empfangen eines Referenzsignals von einem Steueranschluß für automatische Verstärkungssteuerungspegel (90) an einem Eingabeanschluß des Komparators und das Ausgabesignal des Integrators (600) an dem anderen Eingabeanschluß des Komparators, zum Vergleichen der empfangenen Signale miteinander, und zum Senden des resultierenden Signals, das durch den Vergleich erzielt wurde, zu der automatischen Verstärkungssteuerungseinheit (23).

2. Die Vorrichtung für optische Platte nach Anspruch 1, des weiteren umfassend einen Entzerrungsverstärker (30) zum stabilen Ausgeben einer besonderen Frequenz mit einem konstanten Pegel, um beiden, der automatischen Verstärkungssteuerungseinheit (23) und der automatischen Verstärkungssteuerungsdetektoreinheit (25), zu erlauben, Eigenschaften von der besonderen Frequenz anzupassen.

3. Die Vorrichtung für optische Platte nach Anspruch 1 oder 2, wobei beide, die automatische Verstärkungssteuerungseinheit (23) und die automatische Verstärkungssteuerungsdetektoreinheit (25), dazu dienen, Eigenschaften von einer besonderen Frequenz anzupassen, wobei die besondere Frequenz mit einem konstanten Pegel stabil ausgegeben wird.

4. Die Vorrichtung für optische Platte nach Anspruch 1, 2 oder 3, wobei die automatische Verstärkungssteuerungseinheit (23) einen Spannungssteuerungsverstärker (200) umfaßt, der durch Spannung gesteuert wird.

## Revendications

1. Système à disque optique, comprenant :
une unité de lecture (10) pour lire un signal optique provenant d'un disque optique ;
une unité de traitement de signal (40) pour traiter le signal optique ; et
un préamplificateur (50A) comportant :
un amplificateur de fréquences radioélectriques (20) pour amplifier un signal de sortie provenant de l'unité de lecture (10) ;
une unité de commande automatique de gain (23) pour amplifier un signal de sortie provenant de l'amplificateur de fréquences radioélectriques (20) jusqu'à un niveau souhaité ;
une unité de détection de commande automatique de gain (25) reliée sur sa borne d'entrée à une borne de sortie de l'unité de commande automatique de gain et sur sa borne de sortie à une borne d'entrée de l'unité de commande automatique de gain (23), l'unité de détection de commande automatique de gain (25) servant à redresser un signal de sortie provenant de l'unité de commande automatique de gain (23), à comparer le signal redressé avec un signal de référence ayant un niveau prédéterminé et à envoyer le signal qui en résulte obtenu par la comparaison à l'unité de commande automatique de gain (23) ; et
une unité de sélection de mode (60) reliée à l'unité de détection de commande automatique de gain et conçue pour sélectionner un mode parmi plusieurs modes correspondant respectivement à différentes caractéristiques d'égalisation ;
caractérisé en ce que :
ladite unité de détection de commande automatique de gain (25) comporte :
un redresseur à deux alternances (300) pour sortir un signal linéaire redressé sur les deux alternances en réponse à un signal amplifié par l'unité de commande automatique de gain (23) ;
un amplificateur logarithmique (500) pour recevoir le signal linéaire sorti du redresseur à deux alternances (300) et pour sortir un signal amplifié de façon logarithmique ;
un intégrateur (600) pour recevoir le signal de sortie provenant de l'amplificateur logarithmique (500) et pour le convertir en un signal à courant continu ; et
un comparateur (400) pour recevoir un signal de référence provenant d'une borne de commande de niveau de commande automatique de gain (90) sur une de ses bornes d'entrée et le signal de sortie provenant de l'intégrateur (600) sur l'autre de ses bornes d'entrée, pour comparer les signaux reçus les uns avec les autres, et pour envoyer le signal qui en résulte obtenu par la comparaison à l'unité de commande automatique de gain (23).

2. Système à disque optique selon la revendication 1, comprenant en outre un amplificateur d'égalisation (30) pour sortir de façon stable une fréquence particulière à un niveau constant afin de permettre à la fois à l'unité de commande automatique de gain (23) et à l'unité de détection de commande automatique de gain (25) d'ajuster les caractéristiques de la fréquence particulière.

3. Système à disque optique selon la revendication 1 ou 2, dans lequel à la fois l'unité de commande automatique de gain (23) et l'unité de détection de commande automatique de gain (25) servent à ajuster les caractéristiques d'une fréquence particulière, sortant par ce moyen de façon stable la fréquence particulière à un niveau constant.

4. Système à disque optique selon la revendication 1, 2 ou 3, dans lequel l'unité de commande automatique de gain (23) comprend un amplificateur commandé en tension (200) qui est commandé par une tension.
